Europäisches Patentamt

(19) European Patent Office

Office européen des brevets

(11) Publication number : **0 209 562 B1**

## (12) EUROPEAN PATENT SPECIFICATION

(45) Date of publication of patent specification : **24.07.91 Bulletin 91/30**

(51) Int. Cl.5 : **H03M 1/48**

(21) Application number : **86900800.3**

(22) Date of filing : **16.01.86**

(86) International application number : **PCT/GB86/00029**

(87) International publication number : **WO 86/04470 31.07.86 Gazette 86/17**

(54) APPARATUS FOR ANALOGUE TO DIGITAL CONVERSION.

The file contains technical information submitted after the application was filed and not included in this specification

(30) Priority : **16.01.85 GB 8501034**

(43) Date of publication of application : **28.01.87 Bulletin 87/05**

(45) Publication of the grant of the patent : **24.07.91 Bulletin 91/30**

(84) Designated Contracting States : **AT BE CH DE FR IT LI LU NL SE**

(56) References cited :
DE-A- 2 022 267
DE-B- 1 219 975
US-A- 3 577 138
D. Seitzer, G. Pretzl, N.A. Hamdy "Electronic Analog-to-Digital Converters" John Wiley and Sons, 1983, pages 54-56, 58-61, 65-67
M. Dietrich "Zur Verbesserung des Signal-Rausch Verhältnisses von Interpolativen Analog-Digital-Umsetzern" NTG - Fachberichte, 65, 1978 pages 66-72
National Semiconductor Corp., "Linear Databook", 1982, pages 3-7 to 3-34
U. Tietze, Ch Schenk, "Halbleiter-Schaltungstechnik", 5th edition, Springer Verlag Berlin Heidelberg New York 1980, pages 100-103 and 122-124
Motorola Data Book MC54/74 HC 74 pages 5-57 to 5-60
J.C. Candy "A Use of Limit Cycle Oscillations to obtain Robust Analog-to-Digital Converters", IEEE Transactions on Communications, vol. COM-22, no. 8, March 1974, pages 298-305

(56) References cited :
H.A. Spang and P.M. Schultheiss "Reduction of Quantizing Noise by Use of Feedback", IRE Transactions on Communications Systems, December 1962, pages 373-380

(73) Proprietor : **Siemens Plessey Electronic Systems Limited**
Oakcroft Road
Chessington, Surrey KT9 1QZ (GB)

(72) Inventor : **JACKSON, Thomas**
76 Mallard Place Strawberry Vale
Twickenham Middlesex (GB)

(74) Representative : **Nicholson, Ronald**
Intellectual Property Department The Plessey Company plc 2-60 Vicarage Lane
Ilford Essex IG1 4AQ (GB)

## Description

The present invention relates to interpolating analogue to digital converters for effecting analogue to digital conversion.

Known interpolating analogue to digital converters usually comprise a relatively coarse resolution analogue to digital (A/D) converter arranged in a feedback loop in combination with a digital to analogue (D/A) converter ; the D/A converter having much finer resolution than the coarse A/D converter. The coarse A/D converter, typically 6 bits resolution, is sampled at a high sample rate, typically 10MHz, with subsequent averaging of the output samples obtained from the coarse resolution A/D converter.

The quantised signal appearing at the output of the coarse A/D converter is an approximation of the analogue signal fed to it, the approximation being dependent upon the quantum jump or step size of the quantisation and the sample rate used in the quantisation process. At any point in time, the difference between the analogue input signal and the output sample from the coarse A/D converter is known as the quantisation error ; generally termed Q.

The output from the coarse A/D converter is fed to the finer resolution D/A converter, the output of which is fed back and combined with the incoming analogue input signal to be digitised. However the D/A converter utilised also gives rise to errors.

The principle of operation of interpolating analog to digital converters is described in J.C. Candy "A Use of Limit Cycle Oscillations to obtain Robust Analog-to-Digital Converters", IEEE Transactions on Communications, Vol. COM-22, No. 8, March 1974, pp 298 to 305, in which the converter operates in an oscillatory mode to produce a repetitive serial pulse stream, which stream is a digitally coded version of the analog input signal. The pulse stream is fed to a digital low pass or decimating filter to provide a high resolution PCM output.

Another analysis of analog to digital converters employing high sampling rates is given in H.A. Spang and P.M. Schultheiss "Reduction of Quantizing Noise by Use of Feedback", IRE Transactions on Communication Systems, December 1962, pp. 373 to 380 in which the quantisation error from the quantiser is fed back via a delay line system to the input of the converter. Such systems are known as Σ-Δ feedback converters.

A further development of interpolating analog to digital converters is shown in M. Dietrich "Zur Verbesserung des Signal-Rausch Verhaltnisses von Interpolativen Analog-Digital-Umsetzern" NTG - Fachberichte, 65, 1978 pp 66 to 72. Figure 5 in particular shows a simple realisation of a converter for use in digitising telephone speech signals wherein the quantiser is a simple one bit quantiser. The converter employs an integrating or double integrating circuit preceding the one bit quantiser. In view of the very high demands on telephone circuits for simplicity and accuracy, even further improvements are desirable.

In D. Seitzer, G. Pretzl, N.A. Hamdy "Electronic Analog-to-Digital Converters" John Wiley and Sons, 1983, there is described on pp 65 to 77 a voltage to frequency converter employing a similar principle of operation to the analog to digital converters described above, and wherein a capacitor is successively charged and discharged by reference currents.

It is an object of the present invention to provide an interpolating analog to digital converter operating on the principle of limit cycle oscillations, but which has improved simplicity of construction and accuracy of operation compared to the prior art referred to above.

The present invention provides an interpolating analogue to digital converter, comprising :-

a first analogue signal combiner (22) having an input, and an output, and being arranged to receive at said input an analogue input signal ($V_1$) and a quantisation error signal (Q) in analogue form and to provide at said output a combined version of the signals at said input ;

a one step digital quantiser means (24) directly coupled to said output of the first signal combiner for producing a binary valued quantised signal ($D_{OUT}$), and clock means ($F_s$) connected to the quantiser means ;

a second signal combiner (26) having an input and output, the input being coupled to the one step digital quantiser and the input being directly coupled to said output of the first signal combiner whereby to provide at said output of the second signal combiner said quantisation error signal ;

the arrangement being such that said quantiser means provides a pulse train representative of the analog input signal.

In accordance with the invention, the first and second signal combines may simply comprise operational amplifiers, for example the type LF 157 described in National Semiconductor Corp., "Linear Databook", 1982, pages 3-7 to 3-34. Such amplifiers have a relatively high slew rate. In accordance with the invention it is not necessary to employ special purpose integrator circuits, in contrast to the prior art referred to above.

In accordance with the invention, the one step digital quantiser preferably comprises a D-type flip flop, for example that described in Motorola Data Book MC54/74 HC 74 pp 5-57 to 5-60.

An embodiment of the invention will now be described, by way of example, with reference to the accompanying drawings in which :

Figure 1 illustrates a schematic block diagram of an interpolating analogue to digital converter in accordance with the present invention ; and

Figure 2 illustrates a schematic circuit diagram of the interpolating analogue to digital converter shown in Figure 1.

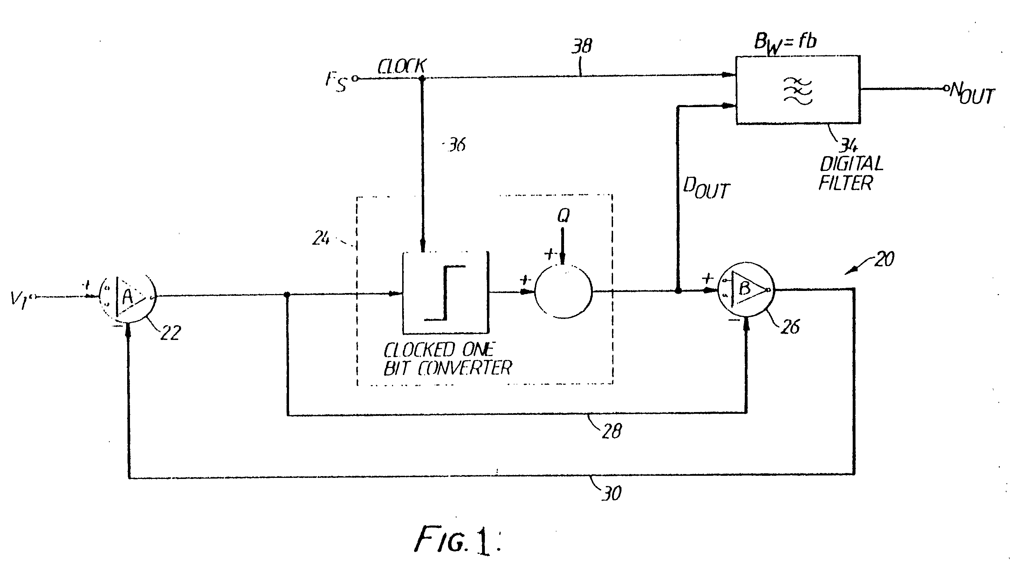

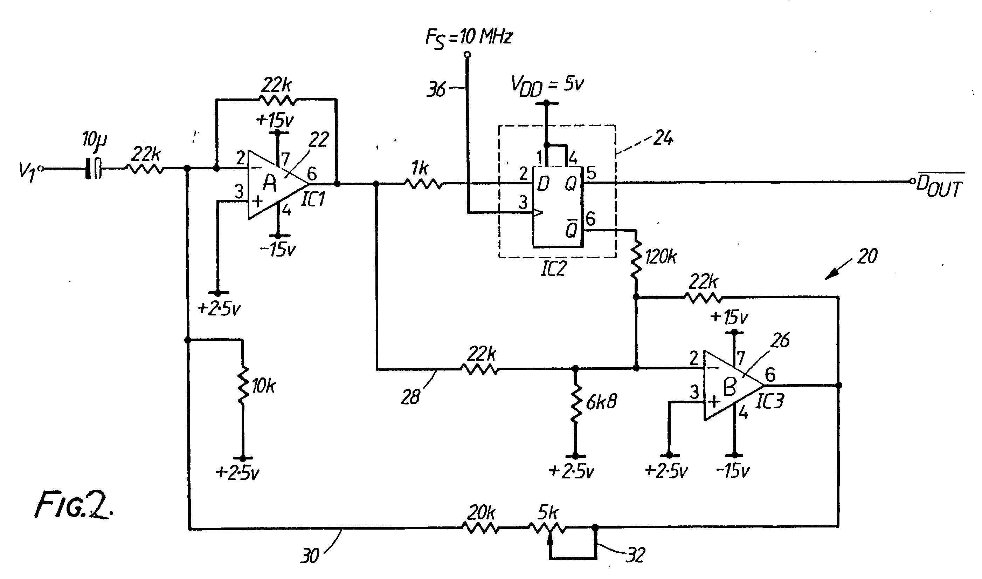

Referring now to Figures 1 and 2 there is shown an interpolating A/D converter 20 in accordance with the present invention. In Figures 1 and 2 like reference numerals have been used to indicate like parts of the A/D converter 20. The A/D converter 20 comprises combiner means in the form of a combiner 22, such as an operational amplifier as shown in Figure 2, for receiving an analogue signal $V_I$. The output of the combiner 22 is connected to one step digital quantiser means in the form of a one bit converter 24, such as a D-type flip flop as shown in Figure 2. The output of the one bit converter 24 is connected to an input of further combiner means in the form of a combiner 26, such as an operational amplifier similar to that utilised for the combiner 22. Feed forward means, such as a feed forward loop 28 is provided to afford the input to the one bit converter 24 to a second input of the combiner 26. The output of the combiner 26 is connected via feedback means in the form of a feedback loop 30 to a further input of the combiner 22. In operation the one bit converter 24 generates quantisation errors Q as it has only a single quantisation step, that is, its output is either at zero or maximum depending upon whether the amplitude of its input signal is above or below a mean threshold value. The combination of the combiner 26 and the feed forward loop 28 provides means for identifying the quantisation errors Q of the one bit converter 24, as described subsequently.

It can be seen from Figure 2 that the feedback loop 30 includes trimmer means such as a potentiometer 32 for trimming the signal fed along the feedback loop 30 to the combiner 22. The output of the converter 24, is also connected to digital filter means, such as a digital filter 34 having a bandwidth $F_b$. A clock (not shown) is also provided for supplying clock pulses at a rate Fs, such as 10MHz, to the converter 24 and the digital filter 34 along lines 36 and 38 respectively. The digital filter 34 may be a finite response filter or an infinite impulse response filter, depending upon operational requirements of the A/D converter 20.

In operation, an analogue signal to be digitised, $V_I$ is fed via the combiner 22 to the converter 24. The converter 24, being a one step or one bit converter produces a digital output signal which is the desired analogue input signal in combination with the quantisation error Q associated with the conversion. However, if the converter 24 is presented with a signal which consists of the analogue input signal plus the expected quantisation error inverted, then the digital output signal, Do, of the converter 24 will consist of a digital representation of the analogue input signal.

The expected quantisation error Q of the converter 24 can be identified by subtracting the input signal to the converter 24 from its output signal. In the A/D converter 20 shown in Figures 1 and 2 this is achieved by affording the analogue input signal to the converter 24 also to the combiner 26 along the feed forward loop 28. The combiner 26 also receives the digital output signal Do from the converter 24 and hence, the quantisation error Q will appear at the output of the combiner 26. The quantisation error Q is fed along the feedback loop 30 to the combiner 22 where it is combined subtractively from the analogue input signal. The analogue input signal minus the quantisation error Q is then presented to the input of the converter 24 and the process is repeated each time the converter 24 is clocked by the clock pulses Fs.

The digital output Do from the converter 24 and the analogue input signal can be combined in this manner because the digital output signal from the converter 24, being a one step or one bit converter, is effectively an analogue voltage. For example, if the converter 24 is capable of providing an output signal having a voltage level of either 0V or +5V, representing, for example logical one and logical zero respectively, it can be seen that such voltage levels may be combined readily with the analogue input signal.

The A/D converter 20 operates in a limit cycle mode of operation to provide a serial output pulse stream $D_{OUT}$ from converter 24 which is a repetitive sequence, the sequence providing a digitally coded version of the analog input $V_I$. The pulse stream is fed to low pass digital filter 34 which operates to provide a high resolution digitally coded output signal $N_{OUT}$.

The performance of the one bit converter 24 shown in Figures 1 and 2 can be expressed in general terms as

$$D_{OUT} = V_I A + Q (1 - AB)$$

where A is the gain of the input path to the converter 24 and B is the gain of the feedback loop 30.

Thus it can be seen that the output of the converter 24, $D_{OUT}$, which is in the form of a repetitive pulse sequence, is dependent on the gain factors A, B of the operational amplifiers 22, 26. It can be seen that when A=B=1, $D_{OUT} = V_I$ that is, cancellation of the quantisation errors may be obtained in the output signal $D_{OUT}$. Thus the repetitive pulse sequence $D_{OUT}$ representing the analog input $V_I$ may not contain any quantisation error.

It can be shown mathematically that, using the arrangement shown in Figure 3 with a digital filter having a bandwidth Fb of 10KHz and a clock having a clock rate Fs of 10MHz, 16 bits resolution can be achieved using, for example, LF157 operational amplifiers as sold by National Semiconductors which is superior to the resolution of known interpolating A/D converters. However, greater resolution can be obtained by using discrete amplifiers with a greater unity gain bandwidth and slew rate. Furthermore, the A/D converter of the present invention does not suffer from the problems with stability described previously with respect to known converters as the total loop gain of the converter is zero.

- In the embodiment shown in Figure 2 the potentiometer 32 is included in the feedback loop 30 so that the signal received by the combiner 22 via the feedback loop 30 is dependent upon the quantisation error of the one bit converter 24. However, the potentiometer 32 may be omitted.

The A/D converter according to the present invention may be fabricated as an integrated circuit, using CMOS technology and such an integrated circuit may or may not include the clock means and the digital filter means.

## Claims

1. An interpolating analogue to digital converter, comprising :-

a first analogue signal combiner (22) having an input, and an output, and being arranged to receive at said input an analogue input signal ($V_1$) and a quantisation error signal (Q) in analogue form and to provide at said output a combined version of the signals at said input ;

a one step digital quantiser means (24) directly coupled to said output of the first signal combiner for producing a binary valued quantised signal ($D_{OUT}$), and clock means ($F_s$) connected to the quantiser means ;

a second signal combiner (26) having an input and output, the input being coupled to the one step digital quantiser and the input being directly coupled to said output of the first signal combiner whereby to provide at said output of the second signal combiner said quantisation error signal ;

the arrangement being such that said quantiser means provides a pulse train representative of the analog input signal.

2. An interpolating converter according to claim 1 wherein the one step digital quantiser means comprises a D-type flip-flop.

3. An interpolating converter according to claim 1 wherein the first and second signal combiners comprise operational amplifiers.

4. An interpolating converter according to any one of the preceding claims further including low pass digital filter means (34) for receiving an output signal from the one step digital quantiser means and having a bandwidth substantially smaller than the clock rate of the digital filter means.

## Patentansprüche

1. Ein Interpolations- analog zu digital Converter umfassend :

einen ersten analogen Signal-Kombinator (22) mit einer Eingabe und einer Ausgabe, und der angeordnet ist, um an besagter Eingabe ein analoges Ein-

gabesignal ($V_1$) und ein Quantisierungs-Fehlersignal (Q) in analoger Form zu empfangen und um an besagter Ausgabe eine kombinierte Version der Signale an besagter Eingabe zu erzeugen ;

ein Einstufen-Digital-Quanitisiermittel (24), direkt gekoppelt an die besagte Ausgabe des ersten Signalkombinators für die Erzeugung eines Binärwert-quanitisierten Signales ($D_{AUS}$) und Taktmittel ($F_s$), verbunden an das Quanitisiermittel ;

einen zweiten Signal-Kombinator (26) mit einer Eingabe und Ausgabe, wobei die Eingabe an das Einstufen-Digital-Quantisiermittel gekoppelt ist und die Eingabe direkt an die besagte Ausgabe des ersten Signalkombinators gekoppelt ist, um an besagter Ausgabe des zweiten Signalkombinators das besagte Quantisierungs-Fehlersignal zu erzeugen ;

wobei die Anordnung derart ist, dass das Quantisiermittel eine Impulsserie erzeugt, die repräsentativ ist für das analoge Eingabesignal.

2. Ein Interpolations-Converter nach Anspruch 1, worin das Einstufen-Quantisiermittel einen D-Typ Flip-Flop umfasst.

3. Ein Interpolations-Converter nach Anspruch 1, worin der erste und der zweite Signalkombinator Operationsverstärker umfassen.

4. Ein Interpolations-Verstärker nach irgendeinem der vorangehenden Ansprüchen, weiter beinhaltend Tiefpass-Digital-Filtermittel (34) für den Empfang eines Ausgabesignals vom Einstufen-Digital-Quantisiermittel und die eine Bandbreite umfassen, welche wesentlich kleiner ist als die Taktfrequenz der Digitalfiltermittel.

## Revendications

1. Convertisseur analogique-numérique à interpolation, comprenant

un premier combinateur (22) de signaux analogiques ayant une entrée et une sortie, et disposé afin qu'il reçoive, à l'entrée, un signal analogique d'entrée ($V_1$) et un signal d'erreur de quantification (Q) sous forme analogique, et qu'il transmette à la sortie une version combinée des signaux présents à l'entrée,

un dispositif numérique (24) de numérisation à un seul pas directement couplé à la sortie du premier combinateur de signaux et destiné à créer un signal numérisé ($D_{OUT}$) de valeur binaire et une horloge ($F_s$) connectée au dispositif de numérisation,

un second combinateur (26) de signaux ayant une entrée et une sortie, l'entrée étant couplée au circuit numérique de numérisation à un seul pas et l'entrée étant directement couplée à la sortie du premier combinateur de signaux afin que le signal d'erreur de quantification soit transmis à la sortie du second combinateur de signaux,

la disposition étant telle que le dispositif de numérisation transmet un train d'impulsions représentatif du signal analogique d'entrée.

2. Convertisseur à interpolation selon la revendication 1, dans lequel le dispositif numérique de numérisation à un seul pas est une bascule de type D.

3. Convertisseur à interpolation selon la revendication 1, dans lequel le premier et le second combinateur de signaux sont des amplificateurs opérationnels.

4. Convertisseur à interpolation selon l'une quelconque des revendications précédentes, comprenant en outre un dispositif (34) de filtrage numérique passe-bas destiné à recevoir un signal de sortie du dispositif numérique de numérisation à un seul pas et ayant une largeur de bande nettement inférieure à la fréquence d'horloge du dispositif de filtrage numérique.

FIG.1:

EP 0 209 562 B1

FIG.2.